# EUROPEAN PATENT SPECIFICATION

(11) **EP 2 182 561 B1**
(45) Date of publication and mention of the grant of the patent: **14.08.2013**
(21) Application number: 09173491.3
(22) Date of filing: 20.10.2009
(51) Int. Cl.: H01L 41/22

(54) **Method for manufacturing electronic device and method for manufacturing piezoelectric device**
Verfahren zur Herstellung eines elektronischen Geräts und Verfahren zur Herstellung einer piezoelektrischen Vorrichtung
Procédé de fabrication d'un dispositif électronique et procédé de fabrication d'un dispositif piézoélectrique

(30) Priority: 31.10.2008 JP 2008282567
(43) Date of publication of application: 05.05.2010
(73) Proprietor: Murata Manufacturing Co., Ltd., Nagaokakyo-shi, Kyoto-fu 617-8555 (JP)
(72) Inventor: Iwamoto, Takashi, Kyoto-fu 617-8555 (JP)
(74) Representative: Thévenet, Jean-Bruno

(56) References cited:
- FR-A1- 2 914 492
- US-B1- 6 465 327

## Description

### BACKGROUND OF THE INVENTION

### 1. Field of the Invention

The present invention relates to a method for manufacturing an electronic device that uses a crystalline material, and particularly to a method for manufacturing a thin film piezoelectric single crystal device.

### 2. Description of the Related Art

Various electronic devices such as semiconductors and piezoelectric bodies that use a crystalline material having certain electrical characteristics are currently manufactured and used. Among the various electronic devices, a surface acoustic wave (SAW) device, a film bulk acoustic resonator (F-BAR) device, and the like are exemplified as a piezoelectric device. Furthermore, many thin film piezoelectric devices obtained by thinning a piezoelectric body are developed as the piezoelectric device partly because they support high-frequency Lamb wave devices. A method for manufacturing a piezoelectric thin film for forming such a thin film piezoelectric device is disclosed, for example, in Y. Osugi et al.: "Single crystal FBAR with LiNO3 and LiTaO3", 2007 IEEE MTT-S International Microwave Symposium, pp. 873-876 (Non-Patent Document 1) and Japanese Unexamined Patent Application Publication (Translation of PCT Application) No. 2002-534886 (Patent Document 1).

Further examples may be found in Patent Documents US 6 465 327 and FR 2 914 492.

Non-Patent Document 1 discloses a deposition method in which a material constituting a piezoelectric single crystal such as AlN or ZnO is deposited by sputtering or chemical-vapor deposition (CVD) and a polishing method in which a piezoelectric single crystal substrate having a certain thickness is bonded to a supporting substrate and then thinned by polishing.

Patent Document 1 discloses a method called a smart cut method. In the smart cut method, for example, a LiNO₃ substrate or a LiTaO₃ substrate (particularly a piezoelectric substrate composed of such a material is hereinafter referred to as an LN substrate or an LT substrate) is used as a piezoelectric material and the subsequent processes are performed: (1) an ion implantation layer is formed at a certain depth, where a piezoelectric thin film is to be formed, from the surface of a piezoelectric substrate by implanting ions into the piezoelectric substrate under certain conditions; and (2) the piezoelectric substrate in which the ion implantation layer has been formed is heated. Through such heating treatment, the piezoelectric thin film is obtained from the piezoelectric substrate using the ion implantation layer as a detaching interface.

However, in the case where the deposition method described above is used, the material is limited to AlN or the like because of, for instance, film formation temperature or film formation conditions for obtaining a desired oriented film. Furthermore, since the orientation direction of a crystal axis cannot be controlled, it is difficult to form a crystal in consideration of vibration mode.

In the case where the polishing method described above is used, since the portion other than the piezoelectric thin film is treated as polishing waste, the use efficiency of the piezoelectric material is extremely low. In addition, it is difficult to form a piezoelectric thin film entirely having a uniform thickness due to polishing conditions, variation of the shape of the original piezoelectric substrate, or the like, which decreases productivity.

In the case where the smart cut method described above is used, heating is performed in the detachment step that uses the ion implantation layer. However, since the heating needs to be performed at a high temperature of about 450°C, the following problems arise.

(A) Since the Curie temperature of the piezoelectric substrate is lower than the heating temperature, the piezoelectric substrate is heated to a temperature higher than its Curie temperature. As a result, its piezoelectricity degrades, and the piezoelectric characteristics of the piezoelectric thin film after detachment are deteriorated.

(B) When an LN substrate or an LT substrate is used as the piezoelectric substrate, oxygen in the piezoelectric substrate diffuses to the outside due to high-temperature heating. Thus, the insulation of the piezoelectric thin film obtained by performing detachment of the piezoelectric substrate near its surface degrades, and its piezoelectric characteristics are deteriorated.

(C) When an electrode is formed on the surface of the piezoelectric thin film side of the piezoelectric substrate, a metallic element constituting the electrode diffuses into the piezoelectric thin film due to high-temperature heating. Consequently, the crystal structure of the piezoelectric thin film is broken and transmission loss in the piezoelectric thin film is increased.

(D) In the structure in which the piezoelectric thin film is supported by a supporting substrate, the coefficients of linear expansion between the piezoelectric thin film and the supporting substrate need to be as close as possible to each other. Otherwise, breakages are caused at the joint between the piezoelectric thin film and the supporting substrate due to the difference in coefficients of linear expansion during high-temperature heating. This leads to a constraint of a material of the supporting substrate.

(E) Since the temperature cannot be rapidly increased to the end-point temperature and then rapidly decreased during heating treatment, higher heating temperature means longer tact time.

### SUMMARY OF THE INVENTION

Accordingly, it is an object of the present invention to provide a method for manufacturing an electronic device that uses a crystalline material such as a piezoelectric device that can solve the problems caused by performing heating.

According to preferred embodiments of the present invention, a method for manufacturing a piezoelectric device includes a step of forming an ion implantation layer by implanting ions into a crystalline piezoelectric substrate composed of lithium tantalate; and a step of detaching a layer of the LiTaO₃ piezoelectric substrate in which the ion implantation layer has been formed to form a piezoelectric thin film by heating the piezoelectric substrate, wherein, in the step of detaching a layer of the LiTaO₃ piezoelectric substrate to form the piezoelectric thin film, the piezoelectric substrate in which the ion implantation layer has been formed is heated at a reduced pressure of 0.1Pa or less at a heating temperature determined in accordance with the reduced pressure whereby to avoid oxygen desorption of the LiTaO₃ substrate in the detaching step.

In this manufacturing method, the crystalline piezoelectric substrate is composed of LiTaO₃ and detachment is conducted at a low temperature by performing heating at a reduced pressure of 0.1 Pa or less compared with the existing case where detachment is conducted by performing heating at atmospheric pressure (1.01325 x 10⁵ Pa). This is because the implanted ions are easily gasified at a low temperature at a reduced pressure compared with at atmospheric pressure, and the difference between the pressures of the ion implantation layer and the crystalline substrate easily becomes large at a low temperature, which facilitates cracking and detachment. This means that the detachment is achieved at a temperature lower than before, and the electrical characteristics of the crystalline substrate are prevented from degrading due to high-temperature heating.

In the piezoelectric substrate, with the stress caused during gasification, an electric discharge occurs around the ion implantation layer due to the charge distribution caused by the pyroelectricity of a piezoelectric single crystal. This electric discharge more easily occurs at a reduced pressure than at atmospheric pressure, and the cracking of the crystal structure around the ion implantation layer is facilitated due to the electric discharge. Consequently, detachment is facilitated. Therefore, the detachment at a temperature lower than before is achieved, and the various characteristics of the piezoelectric substrate are prevented from degrading due to high-temperature heating.

The method for manufacturing a piezoelectric device according to preferred embodiments of the present invention may further include a step of forming a supporting body on the piezoelectric substrate in which the ion implantation layer has been formed, the supporting body being formed on a side on which the piezoelectric thin film is to be formed using the ion implantation layer, wherein, in the step of detaching a layer of the piezoelectric substrate to form the piezoelectric thin film, the piezoelectric substrate on which the supporting body has been formed is heated at a reduced pressure at a heating temperature determined in accordance with the reduced pressure.

In this manufacturing method, even if the supporting body that supports the piezoelectric thin film is bonded to the piezoelectric thin film to form a composite substrate, heated detachment at a low temperature as described above can be achieved. Thus, the various characteristics of the piezoelectric thin film that is part of the composite substrate are prevented from degrading due to high-temperature heating.

In the method for manufacturing a piezoelectric device according to preferred embodiments of the present invention, it is permissible for the piezoelectric substrate to have a coefficient of linear expansion different from that of the supporting body.

In this manufacturing method, even if the piezoelectric substrate (piezoelectric thin film) has a coefficient of linear expansion different from that of the supporting body, low heating temperature can prevent breakage caused by the different coefficients of linear expansion.

In the method for manufacturing a piezoelectric device according to preferred embodiments of the present invention, an adhesive layer may be formed on the piezoelectric substrate and an adhesive surface of the supporting body is directly bonded to the adhesive layer by surface activated bonding.

In this manufacturing method, since the heating during bonding is not required because of the surface activated bonding, breakages caused by the different coefficients of linear expansion can be prevented with more certainty.

In the method for manufacturing a piezoelectric device according to preferred embodiments of the present invention, it is advantageous for the supporting body to be formed of a material having good thermal conductivity to the piezoelectric substrate.

In this manufacturing method, the degradation of electrical characteristics described above is suppressed by keeping a piezoelectric substrate to have good thermal conductivity. Furthermore, a piezoelectric device having good can be formed.

The method for manufacturing a piezoelectric device according to preferred embodiments of the present invention may further include, before the step of bonding the piezoelectric substrate to the supporting body, a step of forming an electrode on at least one of a surface of the piezoelectric substrate, the surface positioning on a side on which the piezoelectric thin film is to be formed, and a surface of the supporting body to which the piezoelectric substrate is to be bonded.

In this manufacturing method, even if an electrode is in contact with the surface of the piezoelectric thin film, the diffusion of a metal constituting the electrode into the piezoelectric thin film is suppressed due to low heating temperature. This can suppress an increase in transmission loss in the piezoelectric thin film.

In the method for manufacturing a piezoelectric device according to preferred embodiments of the present invention, advantageously the reduced pressure is set such that piezoelectricity of the piezoelectric substrate hardly degrades at the heating temperature determined in accordance with the reduced pressure.

In the method for manufacturing a piezoelectric device according to preferred embodiments of the present invention, the reduced pressure is set such that oxygen desorption of the piezoelectric substrate hardly occurs at the heating temperature determined in accordance with the reduced pressure.

In this manufacturing method, the reduced pressure is set to be a pressure that achieves heated detachment at a temperature that does not cause oxygen desorption of the piezoelectric substrate. For the LT substrate, the reduced pressure is set to be about 1 x 10⁻⁶ to 0.1 Pa to achieve a heating temperature of about 250°C or less, which suppresses oxygen desorption of the piezoelectric substrate.

In the method for manufacturing a piezoelectric device according to preferred embodiments of the present invention, the heating temperature is advantageously set such that a metal constituting the electrode hardly diffuses to the piezoelectric substrate due to the heating temperature.

In this manufacturing method, a specific value of the heating temperature is set to be a temperature that does not cause the diffusion of a metal from the electrode to the piezoelectric substrate. For the LT substrate in the case where the electrode is composed of Al, the heating temperature is set to be about 250°C or less, which suppresses the diffusion of a metal constituting the electrode to the piezoelectric substrate.

In this manufacturing method, since the piezoelectric substrate is composed of lithium tantalate (LiTaO₃), there is no degradation of the characteristics described above. Thus, a piezoelectric device having better characteristics can be formed.

According to the present invention, when a piezoelectric device that uses a crystalline material is manufactured by a smart cut method, the degradation of characteristics caused by performing heating can be prevented and a piezoelectric device having good characteristics can be manufactured.

Other features, elements, characteristics and advantages of the present invention will become more apparent from the following detailed description of preferred embodiments of the present invention with reference to the attached drawings.

### BRIEF DESCRIPTION OF THE DRAWINGS

Fig. 1 is a flowchart showing a method for manufacturing a thin film piezoelectric device according to embodiments of the present invention;
Fig. 2 schematically shows a manufacturing process of the thin film piezoelectric device formed in accordance with the manufacturing flow shown in Fig. 1;
Fig. 3 schematically shows a manufacturing process of the thin film piezoelectric device formed in accordance with the manufacturing flow shown in Fig. 1;
Fig. 4 schematically shows a manufacturing process of the thin film piezoelectric device formed in accordance with the manufacturing flow shown in Fig. 1; and
Fig. 5 is a graph showing the transition of detaching temperature determined in accordance with air pressure when heated detachment is performed.

### DESCRIPTION OF THE PREFERRED EMBODIMENTS

A method for manufacturing an electronic device according to preferred embodiments of the present invention will be described with reference to the drawings. In the following description, a thin film piezoelectric device for a Lamb wave that uses a piezoelectric thin film is exemplified as an electronic device that uses a crystalline material.

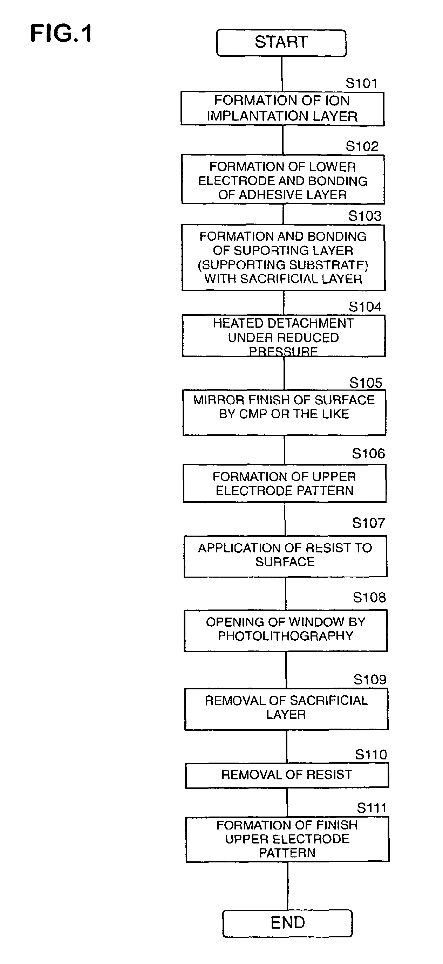

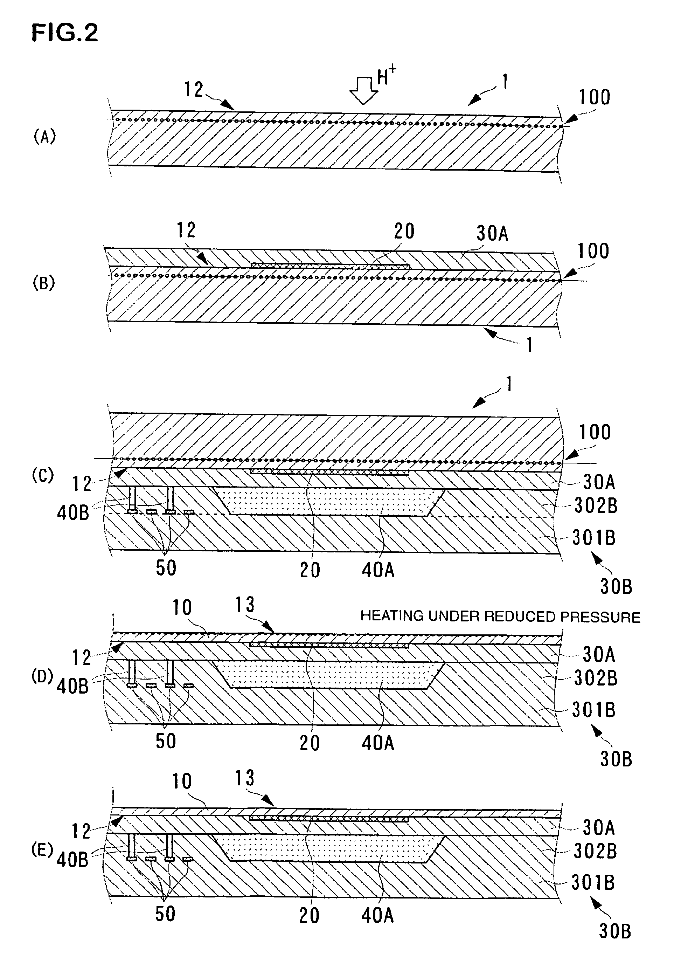

Fig. 1 is a flowchart showing a method for manufacturing a thin film piezoelectric device according to this embodiment. Figs. 2 to 4 schematically show the manufacturing processes of the thin film piezoelectric device formed in accordance with the manufacturing flow shown in Fig. 1.

A piezoelectric single crystal substrate 1 having a certain thickness is prepared. As shown in Fig. 2A, hydrogen ions are implanted from the back face 12 side to form an ion implantation layer 100 (Fig. 1: S101). A mother substrate on which a plurality of separate thin film piezoelectric devices can be arranged is used as the piezoelectric single crystal substrate 1. For example, when an LT substrate is used as the piezoelectric single crystal substrate 1, a hydrogen ion layer is formed at a depth of about 1 µm from the back face 12 by implanting hydrogen ions at a dose amount of about 1.0 × 10¹⁷ atom/cm² with an acceleration energy of about 150 keV. Consequently, the ion implantation layer 100 is formed. Instead of the LT substrate, an LN substrate, a Li₂B₄O₇ (LBO) substrate, or a La₃Ga₅SiO₁₄ (langasite) substrate may be used as the piezoelectric single crystal substrate 1, and ion implantation is performed under conditions suited to each of the substrates. The present invention is not limited to the use of hydrogen ions. The skilled person will readily understand that ions of helium, argon or other suitable elements may be used, with any required changes to the dose amounts and acceleration energies.

As shown in Fig. 2B, a lower electrode 20 having a certain thickness is formed on the back face 12 of the piezoelectric single crystal substrate 1 using aluminum (Al) or the like. Furthermore, a adhesive layer 30A is formed on the back face 12 where the lower electrode 20 has been formed (Fig. 1: S102). For example, a SiO₂ film is used as the adhesive layer 30A, and its surface is planarized by polishing such as chemical mechanical polishing (CMP).

A supporting substrate 30B is prepared separately. The supporting substrate 30B is made by forming a supporting layer 302B on a mother substrate 301B. Although the mother substrate 301B can be composed of a piezoelectric material as with the piezoelectric single crystal substrate 1, Si or glass that is easily available and inexpensive and has a thermal expansion coefficient different from that of the piezoelectric single crystal substrate 1 but has good thermal resistance may be used. In this description, the case where Si is used is described. A circuit electrode pattern 50 and the supporting layer 302B composed of SiO₂ are formed on the surface of the mother substrate 301B composed of Si. In addition, by, for instance, etching the supporting layer 302B, a depression is formed in the area corresponding to the region where an IDT electrode or the like described below is to be formed while a through hole is formed in the area corresponding to part of the circuit electrode pattern 50. A material for a sacrificial layer is deposited in the depression and the through hole to form sacrificial layers 40A and 40B, and the surface of the supporting layer 302B is planarized by CMP or the like.

As shown in Fig. 2C, the piezoelectric single crystal substrate 1 is joined to the supporting substrate 30B by directly bonding the supporting layer 302B of the thus-formed supporting substrate 30B to the surface of the adhesive layer 30A using a surface activated bonding technology (Fig. 1: S103). The surface activated bonding herein is a method in which bonding is performed while a joint surface is activated by applying Ar ions or the like under vacuum. This bonding method does not require the application of heat. Even if coefficients of linear expansion between the piezoelectric single crystal substrate 1 and the adhesive layer 30A and between the supporting layer 302B and the mother substrate 301B of the supporting substrate 30B are different as described above, breakages can be prevented from occurring at each interface because the joint surface is not heated by performing such surface activated bonding. Furthermore, since heat is not applied to the piezoelectric single crystal substrate 1, the degradation of characteristics caused by performing heating can be prevented. Moreover, since an OH group is not used (unlike hydrophilic bonding), voids or the like caused by generation of hydrogen can also be prevented.

As shown in Fig. 2D, the piezoelectric single crystal substrate 1 to which the supporting substrate 30B is bonded is heated under a reduced pressure to conduct detachment using the ion implantation layer 100 as a detaching interface (Fig. 1: S104). As a result, a piezoelectric thin film 10 that is supported by the supporting substrate 30B is formed.

In accordance with the reduced pressure, the heating is conducted only to a temperature lower than the temperature at which heating is conducted at atmospheric pressure. Specifically, the reduced pressure and the heating temperature are set in consideration of the following conditions.

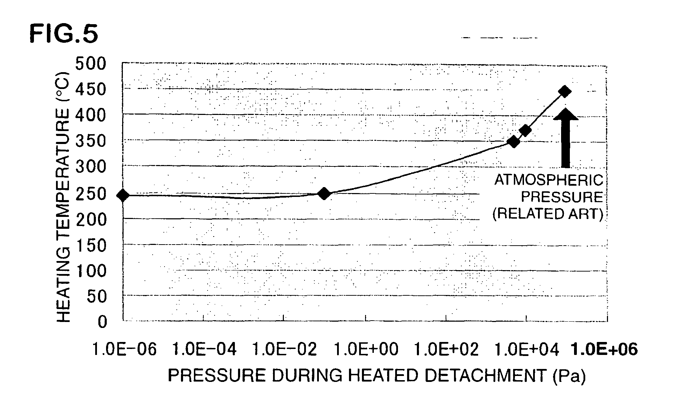

Fig. 5 shows the transition of detaching temperature determined in accordance with air pressure when heated detachment is performed.

As shown in Fig. 5, the detaching temperature is decreased at a reduced pressure that is lower than atmospheric pressure. For example, the detaching temperature is about 450°C at atmospheric pressure whereas it is about 350°C at about 5000 Pa. When the pressure is further reduced to about 0.1 Pa, the detaching temperature is decreased to about 250°C.

The decrease in the detaching temperature due to reduced pressure is considered to be for the following reasons.

(1) The implanted hydrogen ions are easily gasified at a low temperature at a reduced pressure compared with at atmospheric pressure, and the difference between the pressures of the ion implantation layer 100 and the residual layer the piezoelectric single crystal substrate 1 easily becomes large at a low temperature. Therefore, the cracking and detachment are facilitated.

(2) With the stress caused during gasification, an electric discharge occurs around the ion implantation layer 100 due to the charge distribution caused by the pyroelectricity of the piezoelectric single crystal substrate 1. This electric discharge more easily occurs at a reduced pressure than at atmospheric pressure, and the cracking of the crystal structure around the ion implantation layer 100 is facilitated due to the electric discharge.

For an LT single crystal or an LN single crystal, the detaching temperature reduced to about 350°C is less than or equal to its Curie temperature. Thus, the degradation of the piezoelectricity can be prevented.

When the detaching temperature is reduced to about 250°C, the insulation of the LT single crystal can be prevented from degrading while the diffusion of Al constituting the lower electrode 20 to the LT single crystal that is the piezoelectric single crystal substrate 1 can be suppressed. Even in the case where the circuit electrode pattern 50 is formed in the supporting substrate 30B as described above, a metal constituting the circuit electrode pattern 50 can be prevented from diffusing to the supporting substrate 30B (particularly supporting layer 302B), thus the degradation of characteristics can be prevented.

Since the stress caused by performing heating can be suppressed when heating temperature is lowered even if coefficients of linear expansion are different, breakages caused by the stress can be suppressed. Thus, even a material that has good temperature characteristics and good electric power resistance but has a thermal expansion coefficient different from that of the piezoelectric single crystal substrate 1 can be used for a supporting substrate. Since this makes various supporting substrates available, a less expensive supporting substrate can be selected.

In such a heating step, the temperature is not rapidly increased or decreased, and needs to be gradually increased or decreased in accordance with a certain profile. Therefore, the throughput in the heating step can be increased by decreasing the heating temperature (end-point temperature). In this case, pressure reducing treatment needs to be performed compared with the case where heated detachment is conducted at atmospheric pressure. However, since the time required for reducing and increasing pressure is shorter than the time required for decreasing and increasing temperature, the throughput in the heating step can be increased compared with that in the existing heating step, thus productivity can be improved.

As shown in Fig. 2E, a detaching interface (surface) 13 of the piezoelectric thin film 10 is polished to a mirror-smooth state by CMP or the like (Fig. 1: S105). Such mirror finish of the surface 13 can improve the characteristics as a piezoelectric device.

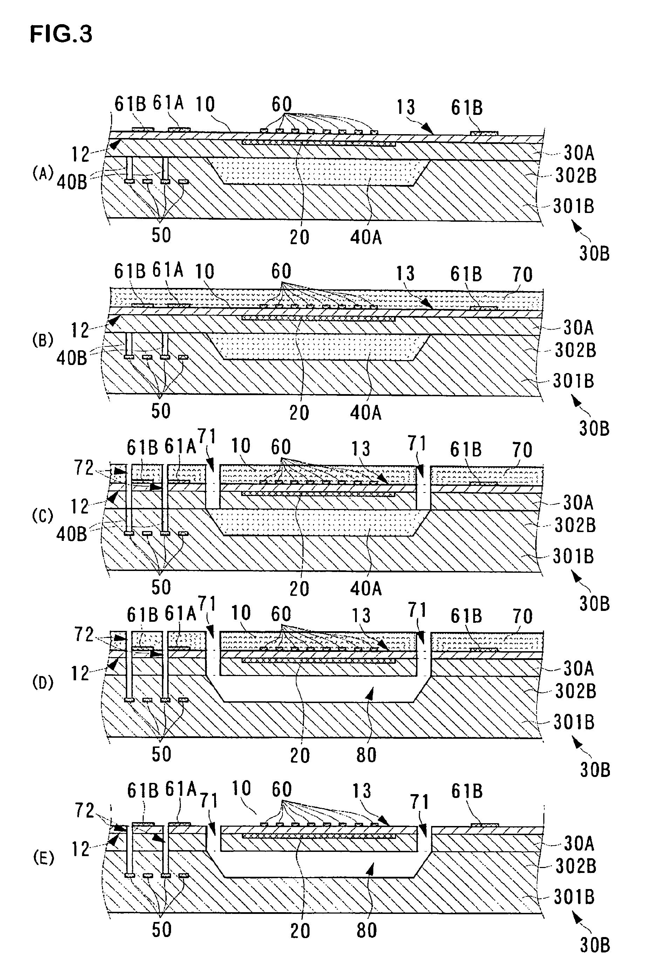

As shown in Fig. 3A, a surface electrode pattern including an IDT electrode 60 to be an excitation electrode of a Lamb wave device, a wiring electrode 61A, and a bump pad 61B are formed on the surface 13 of the piezoelectric thin film 10 (Fig. 1: S106).
As shown in Fig. 3B, a resist film 70 is formed on the surface 13 of the piezoelectric thin film 10 on which the upper electrode pattern has been formed (Fig. 1: S107). As shown in Fig. 3C, etching windows 71 and 72 for removing the sacrificial layers 40A and 40B are formed in the resist film 70 by photolithography (Fig. 1: S108).

As shown in Fig. 3D, the sacrificial layers 40A and 40B are removed by introducing an etching solution or an etching gas into the etching windows 71 and 72. As a result, the space in which the sacrificial layer 40A was formed, and that corresponds to the region where the lower electrode 20 and the IDT electrode 60 of a single thin film piezoelectric device are formed, is changed to a depletion layer 80 (Fig. 1: S109). After the removal of the sacrificial layers 40A and 40B, the resist film 70 is removed as shown in Fig. 3E (Fig. 1: S110).

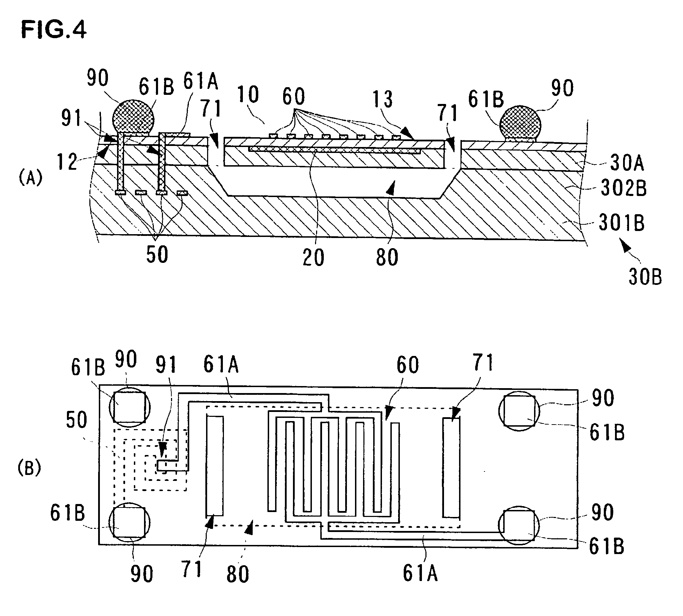

As shown in Fig. 4A, through hole electrodes 91 that connect the circuit electrode pattern 50 to the wiring electrode 61A and the bump pad 61B are formed as a finish upper electrode for completing a thin film piezoelectric device while a bump 90 is formed on the bump pad 61B (Fig. 1: S111). As shown in Fig. 4B, the mother substrate is then cut into individual thin film piezoelectric devices. Thus, a thin film piezoelectric device is formed.

In the distinctive manufacturing method shown in this embodiment, that is, a method including a step of performing heated detachment at a reduced pressure at a low temperature determined in accordance with the reduced pressure, the above problems arising when the existing smart-cut method is used are solved and a thin film piezoelectric device having various good characteristics can be manufactured.

In other words, the degradation of piezoelectricity and insulation is prevented, and a thin film piezoelectric device having good piezoelectricity can be manufactured. Even if an electrode is formed on the surface of a piezoelectric thin film, a metallic element of the electrode is prevented from diffusing into the piezoelectric thin film, and a thin film piezoelectric device with low transmission loss can be manufactured. Since a supporting substrate having a coefficient of linear expansion different from that of the piezoelectric thin film can be used, there is no constraint of a material of the supporting substrate and the supporting substrate can be easily designed with low costs. Furthermore, the throughput in a heated detachment step is improved and productivity can be increased.

In the above description, a method for manufacturing a Lamb wave device has been exemplified. However, the manufacturing method according to this embodiment can also be applied to a SAW device, a F-BAR device, a gyro, a radio frequency (RF) switch, and the like that use a different piezoelectric thin film. The manufacturing method according to this embodiment can be further applied to a pyroelectric device and other crystalline devices.

In the above description, a thin film piezoelectric device having a lower electrode has been exemplified. However, the manufacturing method according to this embodiment can be applied to a thin film piezoelectric device having no lower electrode.
While preferred embodiments of the invention have been described above, it is to be understood that variations and modifications will be apparent to those skilled in the art without departing from the scope of the invention as defined in the following claims.

## Claims

1. A method for manufacturing a piezoelectric device comprising:
a step of forming an ion implantation layer (100) by implanting ions into a crystalline piezoelectric substrate (1) composed of lithium tantalate; and
a step of detaching a layer of the LiTaO₃ piezoelectric substrate in which the ion implantation layer (100) has been formed to form a piezoelectric thin film (10) by heating the piezoelectric substrate (1),
**characterized in that**, in the step of detaching a layer of the LiTaO₃ piezoelectric substrate to form the piezoelectric thin film (10), the piezoelectric substrate (1) in which the ion implantation layer (100) has been formed is heated at a reduced pressure of 0.1Pa or less at a heating temperature determined in accordance with the reduced pressure whereby to avoid oxygen desorption of the LiTaO₃ substrate in the detaching step.

2. The method for manufacturing a piezoelectric device according to Claim 1, further comprising:
a step of forming a supporting body (30B) on the LiTaO₃ piezoelectric substrate (1) in which the ion implantation layer (100) has been formed, the supporting body (30B) being formed on a side (12) on which the piezoelectric thin film (10) is to be formed using the ion implantation layer (100),
wherein, in the step of detaching a layer of the LiTaO₃ piezoelectric substrate to form the piezoelectric thin film (10), the LiTaO₃ piezoelectric substrate (1) on which the supporting body (30B) has been formed is heated at a reduced pressure at a heating temperature determined in accordance with the reduced pressure.

3. The method for manufacturing a piezoelectric device according to Claim 2, wherein the LTaO₃ piezoelectric substrate (1) has a coefficient of linear expansion different from that of the supporting body (30B).

4. The method for manufacturing a piezoelectric device according to Claim 3, wherein an adhesive layer (30A) is formed on the LiTaO₃ piezoelectric substrate (1) and an adhesive surface of the supporting body (30B) is directly bonded to the adhesive layer (30A) by surface activated bonding.

5. The method for manufacturing a piezoelectric device according to any one of Claims 2 to 4, wherein the supporting body (30B) is formed of a material having good thermal conductivity to the LiTaO₃ piezoelectric substrate (1).

6. The method for manufacturing a piezoelectric device according to Claim 4, further comprising, before the step of bonding the LiTaO₃ piezoelectric substrate (1) to the supporting body (30):
a step of forming an electrode (20) on at least one of a surface (12) of the LiTaO₃ piezoelectric substrate (1), the surface (12) positioning on a side on which the piezoelectric thin film is to be formed, and a surface of the supporting body (30B) to which the LiTaO₃ piezoelectric substrate (1) is to be bonded, wherein Al constituting the electrode (20) hardly diffuses to the piezoelectric substrate (1) due to the heating temperature.

## Patentansprüche

1. Verfahren zum Herstellen einer piezoelektrischen Vorrichtung, umfassend:
einen Schritt des Ausbildens einer Ionenimplantationsschicht (100) durch Implantieren von Ionen in ein kristallines piezoelektrisches Substrat (1), das aus Lithiumtantalat besteht, und
einen Schritt des Ablösens einer Schicht des LiTaO₃-piezoelektrischen Substrates, in dem die Ionenimplantationsschicht (100) ausgebildet worden ist, um eine piezoelektrische Dünnschicht (10) durch Erwärmen des piezoelektrischen Substrates (1) auszubilden,
**dadurch gekennzeichnet, daß** in dem Schritt des Ablösens einer Schicht des LiTaO₃-piezoelektrischen Substrates, um die piezoelektrische Dünnschicht (10) auszubilden, das piezoelektrische Substrat (1), in dem die Ionenimplantationsschicht (100) ausgebildet worden ist, bei einem reduzierten Druck von 0,1 Pa oder weniger bei einer Erwärmungstemperatur erwärmt wird, die in Übereinstimmung mit dem reduzierten Druck bestimmt wird, wodurch eine Sauerstoffdesorption des LiTaO₃-Substrates in dem Ablösungsschritt vermieden wird.

2. Verfahren zum Herstellen einer piezoelektrischen Vorrichtung nach Anspruch 1, ferner umfassend:
einen Schritt des Ausbildens eines Trägerkörpers (30B) auf dem LiTaO₃-piezoelektrischen Substrat (1), in dem die Ionenimplantationsschicht (100) ausgebildet worden ist, wobei der Trägerkörper (30B) auf einer Seite (12) ausgebildet wird, auf der die piezoelektrische Dünnschicht (10) unter Verwendung der Ionenimplantationsschicht (100) ausgebildet werden soll,
wobei in dem Schritt des Ablösens einer Schicht des LiTaO₃-Piezoelektrischen Substrates, um die piezoelektrische Dünnschicht (10) auszubilden, das LiTaO₃-piezoelektrische Substrat (1), auf dem der Trägerkörper (30B) ausgebildet worden ist, bei einem reduzierten Druck bei einer Erwärmungstemperatur erwärmt wird, die in Übereinstimmung mit dem reduzierten Druck bestimmt wird.

3. Verfahren zum Herstellen einer piezoelektrischen Vorrichtung nach Anspruch 2, wobei das LiTaO₃-piezoelektrische Substrat (1) einen Koeffizienten der linearen Expansion aufweist, der sich von dem des Trägerkörpers (30B) unterscheidet.

4. Verfahren zum Herstellen einer piezoelektrischen Vorrichtung nach Anspruch 3, wobei eine Adhäsionsschicht (30A) auf dem LiTaO₃-piezoelektrischen Substrat (1) ausgebildet ist und eine Adhäsionsoberfläche des Trägerkörpers (30B) direkt mit der Adhäsionsschicht (30A) mittels oberflächenaktivierten Bondings verbunden ist.

5. Verfahren zum Herstellen einer piezoelektrischen Vorrichtung nach einem der Ansprüche 2 bis 4, wobei der Trägerkörper (30B) aus einem Material ausgebildet ist, das eine gute Wärmeleitfähigkeit zum LiTaO₃-piezoelektrischen Substrat (1) aufweist.

6. Verfahren zum Herstellen einer piezoelektrischen Vorrichtung nach Anspruch 4, ferner umfassend vor dem Schritt des Bondens des LiTaO₃-Piezoelektrischen Substrates (1) auf den Trägerkörper (30)
einen Schritt des Ausbildens einer Elektrode (20) auf wenigstens einer von einer Oberfläche (12) des LiTaO₃-Piezoelektrischen Substrates (1), wobei die Oberfläche (12) auf einer Seite positioniert ist, auf der die piezoelektrische Dünnschicht ausgebildet werden soll, und einer Oberfläche des Trägerkörpers (30B), auf der das LiTaO₃-piezoelektrische Substrat (1) gebondet werden soll, wobei Al, das die Elektrode (20) bildet, aufgrund der Erwärmungstemperatur kaum zum piezoelektrische Substrat (1) diffundiert.

## Revendications

1. Procédé pour la fabrication d'un dispositif piézoélectrique comprenant :
une étape de formation d'une couche d'implantation d'ions (100) en implantant des ions dans un substrat piézoélectrique cristallin (1) constitué de tantalate de lithium ; et
une étape de détachement d'une couche du substrat piézoélectrique de LiTaO₃ dans lequel la couche d'implantation d'ions (100) a été formée pour former une mince couche piézoélectrique (10) par chauffage du substrat piézoélectrique (1),
**caractérisé en ce que**, dans l'étape de détachement d'une couche du substrat piézoélectrique de LiTaO₃ pour former la mince couche piézoélectrique (10), le substrat piézoélectrique (1), dans lequel la couche d'implantation d'ions (100) a été formée, est chauffé à une pression réduite de 0,1 Pa ou inférieure à une température de chauffage déterminée selon la pression réduite afin d'éviter la désorption d'oxygène du substrat de LiTaO₃ dans l'étape de détachement.

2. Procédé pour la fabrication d'un dispositif piézoélectrique selon la revendication 1, comprenant de plus :
une étape de formation d'un corps de support (30B) sur le substrat piézoélectrique de LiTaO₃ (1) dans lequel la couche d'implantation d'ions (100) a été formée, le corps de support (30B) étant formé sur un côté (12) sur lequel la mince couche piézoélectrique (10) est à former en utilisant la couche d'implantation d'ions (100),
dans lequel, dans l'étape de détachement d'une couche du substrat piézoélectrique de LiTaO₃ pour former la mince couche piézoélectrique (10), le substrat piézoélectrique de LiTaO₃ (1), sur lequel le corps de support (30B) a été formé, est chauffé à une pression réduite à une température de chauffage déterminée selon la pression réduite.

3. Procédé pour la fabrication d'un dispositif piézoélectrique selon la revendication 2, dans lequel le substrat piézoélectrique de LiTaO₃ (1) présente un coefficient de dilatation linéaire différent de celui du corps de support (30B).

4. Procédé pour la fabrication d'un dispositif piézoélectrique selon la revendication 3, dans lequel une couche adhésive (30A) est formée sur le substrat piézoélectrique de LiTaO₃ (1) et une surface adhésive du corps de support (30B) est directement liée à la couche adhésive (30A) par une liaison activée en surface.

5. Procédé pour la fabrication d'un dispositif piézoélectrique selon l'une quelconque des revendications 2 à 4, dans lequel le corps de support (30B) est constitué d'un matériau présentant une bonne conductivité thermique par rapport au substrat piézoélectrique de LiTaO₃ (1).

6. Procédé pour la fabrication d'un dispositif piézoélectrique selon la revendication 4, comprenant de plus, avant l'étape de liaison du substrat piézoélectrique de LiTaO₃ (1) au corps de support (30) :
une étape de formation d'une électrode (20) sur au moins une d'une surface (12) du substrat piézoélectrique de LiTaO₃ (1), la surface (12) étant disposée sur un côté sur lequel la mince couche piézoélectrique doit être formée, et d'une surface du corps de support (30B) sur laquelle le substrat piézoélectrique de LiTaO₃ (1) doit être lié, dans lequel Al constituant l'électrode (20) ne diffuse guère vers le substrat piézoélectrique (1) en raison de la température de chauffage.
